Europäisches Patentamt

(19) European Patent Office

Office européen des brevets

(11) Publication number: **0 206 494**
**B1**

(12) **EUROPEAN PATENT SPECIFICATION**

(45) Date of publication of the patent specification:
02.08.89

(21) Application number: 86303629.9

(22) Date of filing: 13.05.86

(51) Int. Cl.⁴: **C 23 C 14/48**, C 23 C 26/00

(54) Improved cutting edges.

(30) Priority: 17.05.85 GB 8512542

(43) Date of publication of application:
30.12.86 Bulletin 86/52

(45) Publication of the grant of the patent:
02.08.89 Bulletin 89/31

(84) Designated Contracting States:
CH DE FR IT LI SE

(56) References cited:
EP-A-0 175 538
DE-A-326 971
US-A-3 900 636

THIN SOLID FILMS, vol. 117, no. 1, July 1984, pages
L63-L66, Elsevier Sequoia, Lausanne, CH, printed in
NL; L. GUZMAN et al.: "Formation of BN by
nitrogen ion implantation of boron deposits"
PATENTS ABSTRACTS OF JAPAN, vol. 8, no. 106 (C-
223) 1543 , 18th May 1984; & JP-A-59 20 465
(ADAMANDO KOGYO K.K.) 02-02-1984
CHEMICAL ABSTRACTS, vol. 102, no. 22, June 1985,
page 246, abstract no. 188984a, Columbus, Ohio, US;
& DD-A-214 153 (AKADEMIE DER
WISSENSCHAFTEN DER DDR) 03-10-1984
PATENTS ABSTRACTS OF JAPAN, vol. 9, no. 287 (C-
314) 2010 , 14th November 1985; & JP-A-60 131 964
(NITSUSHIN DENKI K.K.) 13-07-1985

(73) Proprietor: **UNITED KINGDOM ATOMIC ENERGY
AUTHORITY, 11 Charles II Street, London SW1Y
4QP (GB)**

(72) Inventor: **Dearnaley, Geoffrey, 11 Clifton Drive,
Abingdon Oxon (GB)**

(74) Representative: **Wood, Paul Austin, Patents Branch
United Kingdom Atomic Energy Authority 11
Charles II Street, London SW1Y 4QP (GB)**

## Description

The present invention relates to the production of cutting edges.

Knives and other cutting edges which are intended for use in corrosive environments may be fabricated from alloys such as those of titanium, or stainless steel. Scalpels in particular are made of titanium alloys because of their lightness. Unfortunately, such materials are softer than those usually used for cutting edges, so that the provision and maintenance of sharp cutting edges is difficult. Attempts to provide hard surfaces by conventional coating processes such as chemical vapour or plasma vapour deposition do not give a sharp edge because the coatings produced are too thick, and often are irregular also.

According to the present invention there is provided a process for producing a self-sharpening cutting edge wherein there is included the operations of depositing in vacuo upon a region of one surface (4) only of a cutting edge of a blade (1) a layer (3) of at least one material which is capable of forming a compound which is harder than the material of the blade (1), and bombarding the deposited material with ions (5) of at least one other material such as to react with the deposited material (3) to form the said compound or compounds the said ions (5) having an energy sufficient to cause at least some ion beam mixing of the compound or compounds with the material of the blade (1), thereby to produce a layer (8) on the said surface (4) which is harder than the remainder of the blade (1) so that in use the untreated surface (2) of the cutting edge of the blade (1) will wear faster than the treated surface (4) so as to make the blade (1) self sharpening.

There may be included also ions of other materials, which may act to provide coatings of mixed compositions, or to enhance the ion beam mixing of the coating with the substrate material.

Suitable materials to be deposited are boron, tungsten, titanium, vanadium or hafnium, and suitable second materials are nitrogen in the form of N+ ions, and/or carbon in the form of CO+ ions. A suitable thickness for the layer of deposited material is 0.1 to 0.2 $\mu$m. A suitable ion dose is at least 25 % of that required for stoichiometry in the surface layer, implanted with energies in the range of 10 to 200 keV.

Not only does the ion bombardment process result in a hard surface layer which does not have a distinct boundary between it and the main body of blade material thus ensuring that it does not become detached in use, but the non-equilibrium nature of the process enables hard compounds to be formed which cannot be achieved by other deposition processes such as chemical or plasma vapour deposition.

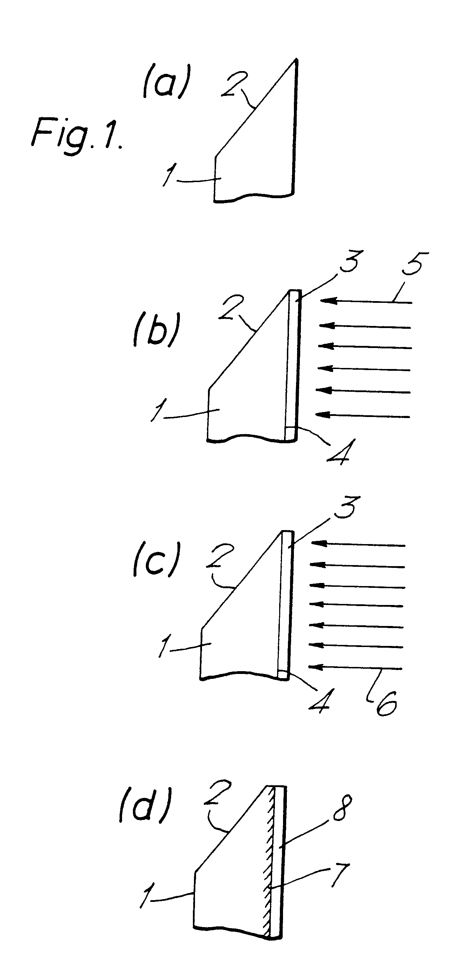

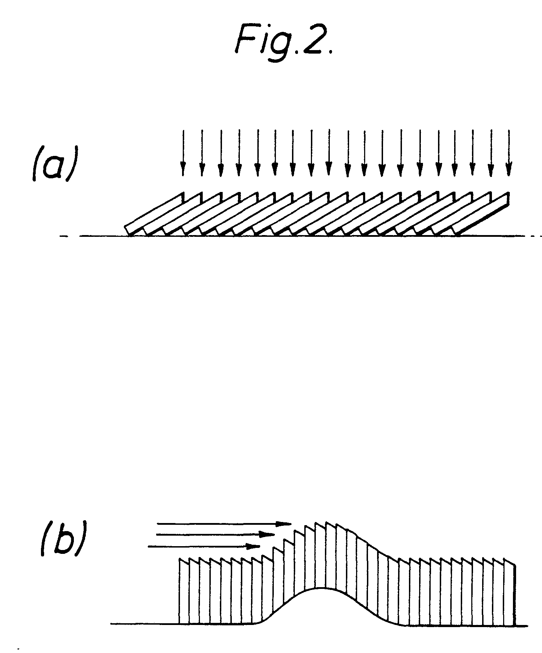

The invention will now be described by way of example, with reference to the accompanying drawings, in which Figure 1 illustrates the stages of a process for carrying out the invention, and Figure 2 shows how a desired distribution of deposited material can be achieved.

Referring to Figure 1, (a) shows a section of a blade 1 having a cutting edge 2 of chisel form. Scalpels and single-edged razor blades are examples of cutting edges of this type. The blade 1 is made of a titanium alloy or a stainless steel. A coating 3, of between 0.1 and 0.2 m of boron is deposited on one surface 4 of the cutting edge 2 of the blade 1, by means of electron beam evaporation 5 from a source which is not shown in Figure 1 (b). The coated surface 4 of the cutting edge 2 of the blade 1 is then bombarded by a beam 6 of nitrogen ions, as is shown in Figure 1 (c). The nitrogen ions have an energy of 10 to 200 KeV, and the bombardment is continued until sufficient nitrogen has been implanted to cause at least 25 per cent of the boron to be converted to boron nitride. In addition to reacting with the boron, the nitrogen ions cause it to migrate into the main body of blade 1 by means of the process known as ion beam mixing. The result is to produce a region of graded composition 7 between the hard surface ceramic layer 8 of boron nitride and the softer main body of the blade 1, as shown in Figure 1 (d). The whole process is carried out in a vacuum of about 10⁻⁵ torr.

In use, the softer main body of the blade 1 wears away preferentially, leaving the hard surface layer 8 and the region 7 exposed to form a self-maintaining fine cutting edge.

If desired, carbon can be implanted with the nitrogen so that the surface layer 8 has a mixed composition of boron carbide and nitride. Other materials which form hard nitrides or carbides, such as tungsten, vanadium, hafnium or titanium can be used. Titanium, of course, would not be used if the blade itself is made of titanium.

In practice, the coating need only be applied to a restricted region of the blade 1. Advantage can be taken of the straight line trajectory of particles in a vacuum to achieve this, either by stacking a plurality of blades 1 at an angle to the incident atoms and ions, as shown in Figure 2 or causing them to traverse a hump, 31 in a track, 32 as shown in Figure 2b, so that only the tip 33 of the blades 1 are exposed to the atoms and ions.

## Claims

1. A process for producing a self-sharpening cutting edge wherein there is included the operations of depositing in vacuo upon a region of one surface (4) only of a cutting edge of a blade (1) a layer (3) of at least one material which is capable of forming a compound which is harder than the material of the blade (1), and bombarding the deposited material with ions (5) of at least one other material such as to react with the deposited material (3) to form the said compound or compounds the said ions (5) having an energy sufficient to cause at least some ion beam mixing of the compound or compounds with the material of the blade (1), thereby to produce a layer (8) on the said surface (4) which is harder than the remainder of the blade (1) so that in use the untreated surface (2) of the cutting edge of the blade (1) will wear faster than the treated surface (4) so as to make the blade (1) self sharpening.

2. A process according to claim 1 wherein the one or more materials which can form a compound or compounds harder than the material of the blade (1) is selected from the group comprising boron, tungsten, titanium, vanadium and hafnium.

3. A process according to claim 1 or claim 2 wherein the other material is nitrogen or carbon.

4. A process according to claim 3 wherein the carbon is in the form of carbon monoxide ions.

5. A process according to any preceding claim wherein the layer (3) of deposited material has a thickness between 0.1 and 0.2 μm.

6. A process according to any preceding claim wherein the ion dose of the said other material is greater than 25 per cent of that required for stoichiometry of the said compound or compounds in the surface region (4) of the blade (1).

7. A process according to any preceding claim wherein the ions (5) of the other material are implanted with energies in the range of 10 to 200 keV.

**Patentansprüche**

1. Verfahren zur Herstellung einer selbstschärfenden Schneidkante mit den Schritten der Ablagerung einer Schicht (3) zumindest eines Materials, welches zur Erzeugung einer Verbindung, die härter ist als das Material einer Klinge (1), ausgebildet ist im Vakuum auf nur eine Oberfläche (4) einer Schneidkante der Klinge (1), und Beschießen des abgelagerten Materials mit Ionen (5) aus zumindest einem anderen Material, damit diese mit dem abgelagerten Material (3) zur Herstellung der Verbindung oder von Verbindungen reagieren, wobei die Ionen (5) eine Energie aufweisen, die ausreicht, um zumindest eine gewisse Ionenstrahlmischung der Verbindung oder Verbindungen mit dem Material der Klinge (1) zu bewirken und derart eine Schicht (8) auf der Oberfläche (4) zu erzeugen, die härter ist als der übrige Teil der Klinge (1), so daß im Gebrauch die unbehandelte Oberfläche (2) der Schneidkante der Klinge (1) sich schneller abnutzt als die behandelte Oberfläche (4), um die Klinge (1) selbstschärfend auszubilden.

2. Verfahren nach Anspruch 1, bei welchem das Material oder die Materialien, welche eine Verbindung oder Verbindungen bilden können, die härter ist beziehungsweise sind als das Material der Klinge (1), aus der Bor, Wolfram, Titan, Vanadium und Hafnium umfassenden Gruppe ausgewählt ist.

3. Verfahren nach Anspruch 1 oder 2, bei welchem das andere Material Stickstoff oder Kohlenstoff ist.

4. Verfahren nach Anspruch 3, bei welchem der Kohlenstoff in Form von Kohlenstoffmonoxidionen vorliegt.

5. Verfahren nach einem der voranstehenden Ansprüche, bei welchem die Schicht (3) aus abgelagertem Material eine Dicke zwischen 0,1 und 0,2 μm aufweist.

6. Verfahren nach einem der voranstehenden Ansprüche, bei welchem die Ionendosis des anderen Materials mehr als 25 % größer ist als für die Stöchiometrie der Verbindung oder der Verbindungen in dem Oberflächenbereich (4) der Klinge (1) erforderlich.

7. Verfahren nach einem der voranstehenden Ansprüche, bei welchem die Ionen (5) des anderen Materials mit Energien im Bereich von 10 bis 200 keV implantiert werden.

**Revendications**

1. Procédé de fabrication d'une arête de coupe à auto-affûtage dans lequel sont incluses les opérations consistant à déposer sous vide, sur uniquement une région d'une surface (4) de l'arête de coupe d'une lame (1), une couche (3) d'au moins une matière qui est capable de former un composé qui est plus dur que la matière de cette lame (1) et à bombarder cette matière déposée par des ions (5) d'au moins une autre matière de façon qu'elle réagisse avec ladite matière déposée (3) en formant le ou les composés, ces ions (5) ayant une énergie suffisante pour provoquer au moins un certain mélange par le faisceau ionique de ce ou ces composés avec la matière de la lame (1), en formant sur la surface précitée (4) une couche (8) qui est plus dure que le reste de cette lame (1), de façon qu'à l'utilisation la surface non traitée (2) de l'arête de coupe de ladite lame (1) s'use plus rapidement que la surface traitée (4) en rendant la lame (1) auto-affûtante.

2. Procédé selon la revendication 1, dans lequel la ou les matières qui peuvent former un ou des composés plus durs que la matière de la lame (1) sont choisis dans le groupe qui comprend le bore, le tungstène, le titane, le vanadium et le hafnium.

3. Procédé selon la revendication 1 ou la revendication 2, dans lequel l'autre matière est l'azote ou le carbone.

4. Procédé selon la revendication 3, dans lequel le carbone est sous la forme d'ions d'oxyde de carbone.

5. Procédé selon l'une quelconque des revendications précédentes, dans lequel la couche (3) de matière déposée a une épaisseur comprise entre 0,1 et 0,2 μm.

6. Procédé selon l'une quelconque des revendications précédentes, dans lequel la dose d'ions de l'autre matière est supérieure à 25 % de celle qu'il faut pour la stoéchiométrie du ou des composés dans la région de la surface (4) de la lame.

7. Procédé selon l'une quelconque des revendications précédentes, dans lequel les ions (5) de l'autre matière sont implantés avec une énergie comprise entre 10 et 200 keV.

Fig.1.

(a)

2

1

(b)

3   5

2

1

4

(c)

3

2

1

4   6

(d)

2   8

1   7

# Fig.2.

(a)

(b)